Europäisches Patentamt

European Patent Office

Office européen des brevets

(11) Publication number: **0 205 141 B1**

# EUROPEAN PATENT SPECIFICATION

(45) Date of publication of patent specification: **18.12.91**

(51) Int. Cl.⁵: **H05K 13/00**, H05K 13/04, B25J 15/02

(21) Application number: **86107853.3**

(22) Date of filing: **09.06.86**

(54) Autoprogramming pneumatic gripper.

(30) Priority: **12.06.85 IT 2112885**

(43) Date of publication of application:
**17.12.86 Bulletin 86/51**

(45) Publication of the grant of the patent:
**18.12.91 Bulletin 91/51**

(84) Designated Contracting States:
**DE FR GB**

(56) References cited:
**DE-A- 3 312 483**
**US-A- 4 336 926**
**US-A- 4 456 293**

(73) Proprietor: **BULL HN INFORMATION SYSTEMS ITALIA S.p.A.**
**Via Martiri d'Italia 3**
**I-10014 Caluso (Torino)(IT)**

(72) Inventor: **Salvagno, Elvio**
**Via Torino 34**
**I-10014 Caluso (Torino)(IT)**
Inventor: **Pane, Fausto**
**Via Trieste 29**
**I-10014 Caluso (Torino)(IT)**

## Description

The present invention relates to an autoprogramming pneumatic gripper particularly devoted to the insertion of components on printed wiring plates.

Automatic apparatus for the insertion of electronic components on printed wiring plates have been known for a long time.

Such apparatuses can operate only with electrical components having preestablished size.

In the case components of different size have to be inserted on the PWB, the insertion process must be cut into separate phases.

The automatic insertion apparatuses must be provided with a gripping and handling tool of the components different for each phase.

In alternative, the automatic insertion process must be performed by means of different apparatuses.

With the advent of the so-called "robotic" or flexible automation, versatile apparatuses have been put on the market which are able to carry out operations such as: gripping, arrangement, assembling of different elements. They can also be used for the automatic insertion of components on PWB.

These apparatuses or "Robots" are provided with electrically, pneumatically or hydraulically controlled grippers susceptible to be variably opened and therefore able to handle components having different sizes provided smaller than the maximum opening of the grippers.

Some grippers are provided with sophisticated control means with position sensors which supply feedback signals enabling to change the opening or closing width of the grippers according to the needs. See e.g. US-A- 4 456 293 and DE-A- 3 312 483. Such kind of grippers are very expensive and relatively slow in their operation.

In practice the use of pneumatic grippers is preferred, which grippers are always opened at their maximum for the gripping and the release and which close up to exert a grip, the closing position being established by the handled piece size.

The use of such grippers for the insertion of components on PWB is limited by the fact that, in the release of the component just inserted on the PWB, the gripper fingers or jaws must not touch the components already present on the PWBs, therefore, the release operation must be performed with a minimum opening of the gripper as compared to the gripping position.

This is required because the components are mounted on the PWBs the one next to the other at a distance which, in some cases, does not exceed the few millimeters.

Therefore the grippers must be designed to perform an opening/closing stroke of few millimeters, so that its use is limited to the components whose sizes vary within the same range.

The autoprogramming pneumatic gripper object of the present invention overcomes such inconveniency enabling the handling of components with a size variability of centimeters, releasing the components with a stroke of few millimeters and being controlled in order to remember a required opening condition for the execution of subsequent operations. In this sense the gripper may be defined as autoprogramming.

These results are achieved by the gripper object of the present invention as claimed in claim 1 through the serial or cascade use of double-acting pneumatic cylinder with a stroke of centimeters, whose shaft is connected to a single-acting pneumatic actuator of the diaphragm type, having a stroke of millimeters.

The pneumatic cylinder body is integral to a gripper jaw and the diaphragm actuator shaft is integral to the other jaw.

The conbined control of the two actuators allows the jaw positioning in order to grip any piece having a size varying from 0 to some centimeters, while the piece release and the subsequent gripping of other pieces with equal size is enabled by the control of the diaphragm actuator only.

These and other features of the invention will appear clearly from the following description of a preferred embodiment and from the enclosed drawings where:

Figure 1      shows an autoprogramming pneumatic gripper embodied according to the invention,

Figre 2, 3      shows in diagram the functional characteristics of a diaphragm pneumatic actuator;

Figure 4      shows in diagram the operation of the gripper of fig. 1;

Figure 5      shows a modification to the gripper of Fig. 1.

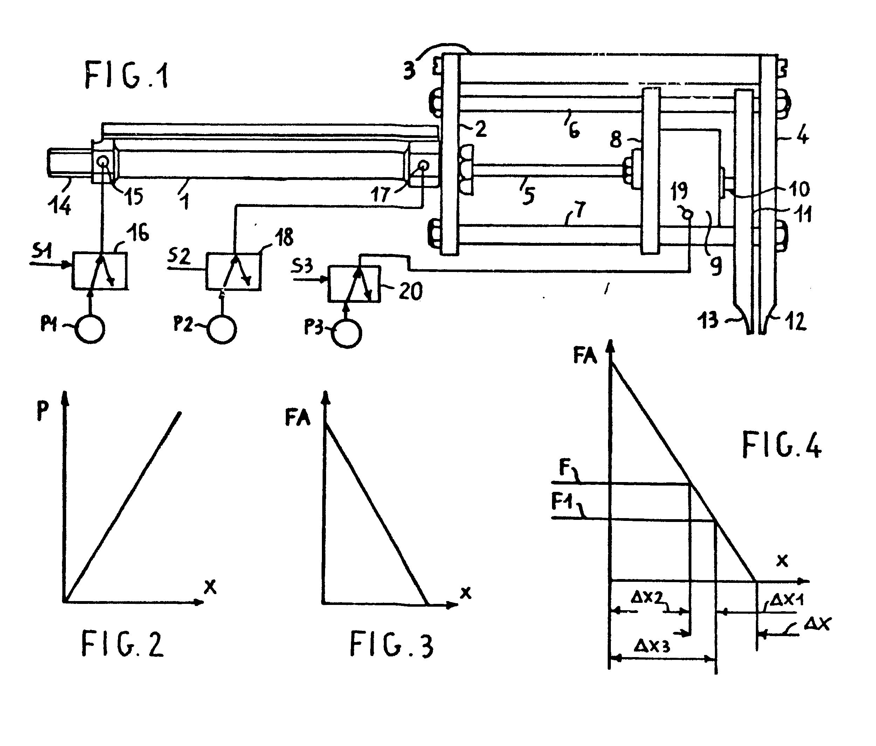

Figure 1 shows in side view a preferred embodiment of the pneumatic gripper of the invention.

The gripper comprises a double-acting pneumatic cylinder 1, a C-shaped frame constituted by a first plate 2, a spacer 3 and a second plate 4 acting as jaw.

Plate 2 is fixed at the end of cylinder 1 perpendicularly to the stroke direction of cylinder shaft 5.

Plates 2 and 4 are parallel each other.

Between the plates, two (or more) guiding bars 6, 7 are fixed parallel to each other and to the stroke direction of the shaft.

At the end of cylinder shaft 5 a bearing plate 8 is fixed, slidably mounted on guiding bars 6, 7 and parallel to plates 2 and 4.

A single-acting diaphragm pneumatic actuator 9 is fixed to bearing plate 8 and its actuation shaft 10 extends towards plate 4.

A plate 11 acting as jaw, is fixed to the free end of shaft 10, and slidably dably mounted on bars 6, 7 parallel to plate 4.

The two plates-jaws 4 and 11 have two gripping beaks 12, 13 faced each other and suitably shaped.

Cylinder 1 and the frame constitute a stiff set which can be suitably fixed to the end of a robot arm, for instance by means of a threaded pin 14 arranged at one end of cylinder 1, or by fixing the spacer 3 to the robot arm.

The Robot can therefore shift the gripper within the spacial coordination tes according to the received instructions, in order that jaw 4 reaches a preestablished position.

Jaw 4 is integral to the robot arm and therefore in a relative fixed position. All the shifts controlled by the robot are referred to such position.

Inlet 15 of cylinder 1 back chamber is connected to a pressure source P1, through electric valve 16.

Electric valve 16 is controlled by an electric signal S1.

When S1 is present (S1 = 1) the back chamber is connected to pressure source P1 and therefore put and kept in pressure.

When S1 is not present (S1 = 0) the back chamber is connected to the atmosphere and therefore released and kept released.

Likewise inlet 17 of front chamber is connected through electric valve 18 to a pressure source P2 which, for sake of simplicity, is considered equal to P1.

Electrical valve 18 is controlled by electric signal S2.

When S2 is present (S2 = 1) the front chamber is put and kept in pressure.

When S2 is not present (S2 = 0) the front chamber is released and kept released.

The single acting pneumatic actuator 9 is obviously provided with only one inlet 19 connected, through an electric valve 20, to a pressure source P3 which is considered equal to P1, for simplicity sake. Electric valve 20 is controlled by an electric signal S3.

When S3 is present (S3 = 1) the actuator is put and kept in pressure.

When S3 is not present (S3 = 0) the actuator is released and kept released.

The stroke of cylinder 1 shaft 5 is preferably of 50 mm., while the stroke of diaphragm actuator 9 shaft 10 is preferably of few millimeters, for instance 4.

From the consideration of fig. 1 it clearly appears that jaw 11 shifts are caused by the combined operation of cylinder 1 and actuator 9 and that the control of cylinder 1 allows shifts ranging from 0 to 50 mm., while the control of actuator 9 adds to such shifts a further shift ranging from 0 to 4 mm.

Now, to understand the operation of the disclosed gripper as concerns the autoprogrammed position and the grip of electrical components or, more generally, of pieces, it is suitable to remind some features of the used actuators.

A double-acting pneumatic cylinder is an actuation means characterized by a great internal friction and therefore a very limited sensitivity to external forces applied to the shaft.

For instance if the cylinder is not fed, the shaft movement is given by a minimum force at least in the order of hundreds of grams or one kilogram.

On the contrary, lacking external loads, the shaft movement is given by a minimum thrust or force of the same order of magnitude, and therefore the application of a pressure difference $\Delta P$ to the chambers, so that $\Delta PS \geq F_1$, where S is the chamber section and $F_1$ the minimum force required to overcome the internal friction.

For an exact formulation it is to be noted that the section of the two chambers differs by the shaft section.

However, the internal friction effect is so relevant as to allow a simplification and, for a wide pressure range P the force F exerted by the cylinder can be expressed as follows:

$$F = \Delta P \, S - F_1$$

Such force, depending on $\Delta P$ is not affected by the position of the cylinder piston, that is by the shaft position.

The behaviour of the diaphragm actuator is completely different. The internal friction of such actuator is negligible, while the exerted force widely depends on the shaft position.

Fig. 2 and 3 shows in qualitative diagram the behaviour of a diaphragm actuator.

Particularly Fig. 2 shows that, lacking external loads the shaft shifting as to the rest position is substantially proportional to the feeding pressure P, that is it shows that the diaphragm exerts an elastic internal reaction proportional to X.

Owing to such reaction the force FA exerted on the shaft is not costant but, keeping the feeding pressure equal, such force decreases according to the shaft displacement from its rest position, as shown by fig. 3.

After these assumption it will be easy to understand the behaviour of the disclosed gripper and how it can be autoprogrammed for the grip and the release of pieces of any size, such release being effected with a minimum opening of the jaws.

The gripper can be initially reset with the jaws completely opened, by command S2 = 1, which put the front chamber of cylinder 1 in pressure, whilst S1 = 0.

With reference to fig. 1, shaft 5 bearing plate 8, diaphragm actuator 9 and jaw 11 are completely shifted leftwards, in a rest position, corresponding to the maximum opening of the jaws and the beaks that is 50 mm.

Once this operation is carried out, command S2 is removed (S2 = 0).

Gripping operation

The so-opened gripper is positioned by the robot in correspondence of the piece to be gripped, that is fixed jaw 4 is positioned in order that its internal side contact a side of the piece to be gripped. With reference to fig. 1, the piece is obviously positioned at the left of a jaw 4.

The diaphragm actuator is fed and kept in pressure by command S3 = 1. Jaw 11 is shifted rightwards with a stroke of about 4 mm. equal to the maximum stroke of the diaphragm actuator.

Straight after, the back chamber of cylinder 1 is put in pressure by command S1 = 1 and plate 8, actuator 9 and jaw 11 shift jointly rightwards up to jaw 11 contacts the left side of the piece.

At this point plate 8 and actuator 9 continue their rightwards stroke for a quantity $\Delta X$ while jaw 11 grips the piece.

In other words a relative shift occurs between actuator 9 and jaw 11, until the gripping force exerted on the piece becomes equal to the thrust F of the cylinder.

Shift $\Delta X$, in the order of millimeters, is shown by diagram of fig. 4 which relates the useful thrust F of the cylinder to the variable thrust FA of the diaphragm actuator.

Locking operation

Without removing signal S1 = 1, signal S2 = 1 puts in pressure the front chamber of cylinder 1 and thrust F exerted by the cylinder becomes nul. At this point two possibilities may occur:
If thrust F previously exerted is lower than thrust $F_1$, necessary for the piston shift, the piston does not move.

The piece stays in a locked status owing to thrust F still exerted by the diaphragm actuator, while cylinder 1 piston is locked in a stable position by the frictions.

If thrust F is higher than thrust $F_1$ the reaction of equal value exerted between gripped piece and diaphragm actuator causes a little shift (leftwards, with reference to fig. 1) of actuator 9, plate 8 and shaft 5 and related piston.

The shift is such that diaphragm actuator 9 expands until the thrust exerted by the actuator on the piece falls to value $F_1$.

The shift is therefore evidenced by the value $\Delta X1$ shown by diagram of fig. 4.

Actually, owing to the system inertia, the shift can be slightly higher but in any case of about tenths of millimeters or at the maximum of mm., and the gripping force arising can be sligthly lower than $F_1$. At the end of such shift both the gripped piece and the cylinder piston are steadily positioned.

Piece-positioning

When all signals S1, S2, S3 are present, the gripped piece can be moved by the robots to the preestablished point.

Piece release

The piece release is obtained by removing signal S3 so allowing actuator tor 9 to reach the rest statue.

A leftwards shifting therefore occurs (with reference to fig. 1) of jaw 11 within the actuator stroke.

Depending on whether the grip thrust was F < $F_1$ or $F_1$ the shift is quantitatively defined by values $\Delta X2$ or $\Delta X3$ evidenced in diagram of fig. 4, and is of about 1-2 mm.

With this shift of jaw 11 the piece release takes place without interferences of the jaw with contiguous pieces.

The operation occurs without shifts of the piston and shaft 5 of cylinder 1 which keeps or "remember" its position for subsequent gripping operations of pieces having equal size.

Gripping of other pieces

If the subsequent pieces to be handled have a size equal or smaller than the one of the already positioned piece, the new operation takes place by positioning the gripper on the piece, making actuator 9 expanded by signal S3 = 1 and confirming the gripping function of cylinder 1 by removing signal S2.

This causes, if necessary, that is if the piece to be gripped is smaller that the one already gripped, a shift of shaft 5, plate 8, actuator 9 and jaw 11 up to the actual gripping of the piece.

Also in this case, with the locking of cylinder 1 obtained by applying again signal S2 = 1, the new gripping position is remembered. On the contrary if the subsequent pieces to be handled have larger size than the piece already gripped, the gripper is moved away from the release zone and the complete opening of the jaws takes place by removing signal S1.

Then the already mentioned gripping, positioning and release sequence takes place.

The previously described embodiment and the related operating modalities only represent one preferred embodiment of the invention and it is clear that several changes can be brought.

In particular the feeding pressure can be different for the two cylinder chambers and for the actuator chamber.

For instance feeding pressure P2 of the front chamber of the cylinder (or contraction chamber) can be lower than the feeding pressure P1 of the back chamber (or expansion chamber) in order that two opposed thrusts, acting on the piston, cause a closing thrust lower than $F_1$ but opposed to the reaction exerted by the gripped piece in order to increase the stability range when gripping.

Also in this case the gripping force is defined by the upper limit of minimum force $F_1$ required to overcome the piston friction.

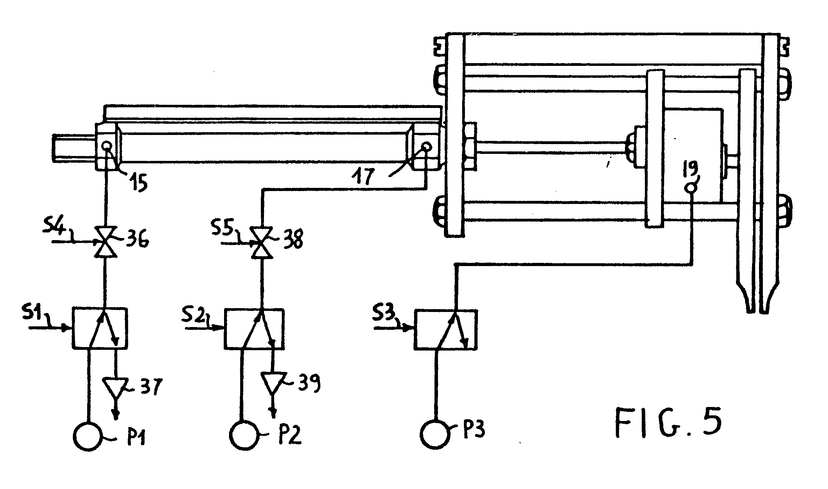

If gripping forces higher than the ones allowed by $F_1$ are required, the embodiment shown in fig. 5 can be considered.

The gripper of fig. 5 differs from the one of fig. 1 because a locking electric valve 36 is positioned between inlet 15 and electric valve 16 and a locking electric valve 38 is positioned between inlet 17 and electric valve 18.

Further electric valves 16 and 18 discharge through a pressure valve 37 and 39 respectively in order to keep a preestablished minimum pressure within the two chambers.

Electric valves 36 and 38 are controlled by an electric signal S4 and S5 respectively.

When S4 = 1 electric valve 36 is opened.

When S4 = 0 electric valve 36 is closed and it practically seals the back chamber of cylinder 1.

The same control function is carried out by signal S5 on electric valve 38.

According to such embodiment, the pressure level P1 within the two chambers can be maintained very high and the autoprogramming operation is obtained by putting in pressure the two chambers with the same pressure value and then by locking them by means of electric valves 36 and 38.

In these conditions it is clear that any shifting of the piston from a balance initial position causes pressure variations between the two chambers and therefore a thrust unbalance tending to recall the piston towards the initial position.

The relation between unbalance force and shifting from the initial position depends on both the used pressure and the piston position within the cylinder.

It is however possible, through a suitable pressure choice, to obtain that, independently from the piston position, the feedback caused by a piston shift as to the balance position be higher than the corresponding thrust variation exerted by actuator 9 for an equal shift.

In this way a piston position is assured independently from the friction force and it is possible to preestablish the gripping force acting on a piece according to the difference between feeding pressure of cylinder 1 and discharging pressure.

## Claims

1. Pneumatic gripper comprising a first (4) and a second (11) gripping jaw, a double-acting pneumatic cylinder (1) integral to said first jaw (4) and provided with movable actuation piston and shaft (5), a diaphragm pneumatic actuator (9) integral to said shaft and provided with actuation element (10) movable in the axial direction of said shaft and integral to said second jaw (11), so that the relative position of said first and second jaw is determined by the combined operation of said cylinder and said actuator.

2. Pneumatic gripper as per claim 1 characterized by that it further comprises guiding bars (6,7) integral to said first jaw, a bearing plate (8) integral to said shaft and slidably mounted on said guiding bars, said actuator being fixed to said plate and said second jaw too being slidably mounted on said guiding bars.

3. Pneumatic gripper as per claim 1 characterized by that it comprises a first control valve (16) for the selective application to the expansion chamber of said cylinder of a pressure P1 and a second control valve (18) to selectively apply to the contraction chamber of said cylinder a pressure P2 lower than said pressure P1.

## Revendications

1. Dispositif de préhension pneumatique comportant une première (4) et une deuxième (11) mâchoires de serrage, un vérin pneumatique (1) à double effet solidaire de ladite première mâchoire (4) et comprenant un piston d'actionnement mobile et un arbre (5), un dispositif d'actionnement pneumatique (9) solidaire dudit arbre et muni d'un élément d'actionnement (10) pouvant se déplacer dans une direction axiale par rapport audit arbre et solidaire de ladite deuxième mâchoire (11) de telle sorte que la position relative desdites première et deuxième mâchoires (11) est déterminée par le fonctionnement combiné dudit vérin et dudit dispositif d'actionnement.

2. Dispositif de préhension pneumatique selon la revendication 1, caractérisé en ce qu'il comporte en outre des barres de guidage (6 et 7) solidaires de la première mâchoire, une plaque-support (8) solidaire dudit arbre 5 et montée coulissante sur lesdites barres de guidage, ledit dispositif d'actionnement étant fixé à ladite plaque et ladite deuxième mâchoire étant aussi montée coulissante sur lesdites barres de guidage.

3. Dispositif de préhension pneumatique selon la revendication 1, caractérisé en ce qu'il comporte une première valve de commande (16) pour l'application sélective d'une pression P1 dans la chambre d'expansion dudit vérin et une seconde valve de commande (18) pour appliquer de façon sélective une pression P2 inférieure à ladite pression P1 à la chambre de contraction dudit vérin.

**Patentansprüche**

1. Pneumatischer Greifer mit einer ersten (4) und einer zweiten Greiferbacke (11); einem mit der ersten Greiferbacke (4) integralen und mit einem beweglichen Betätigungskolben sowie einer Stange (5) versehenen doppeltwirkenden pneumatischen Zylinder (1); sowie einem integral mit der Stange ausgebildeten und mit einem Betätigungselement (10) versehenen pneumatischen Membranantrieb (9), der in Achsrichtung der Stange beweglich und integral mit der zweiten Backe (11) ausgebildet ist, so daß die relative Lage der ersten und der zweiten Backe durch die kombinierte Betätigung des Zylinders und des Antriebs bestimmt wird.

2. Pneumatischer Greifer nach Anspruch 1, **dadurch gekennzeichnet,** daß er ferner mit der ersten Backe integrale Führungsschienen (6, 7) und eine mit der Stange (5) integrale und auf den Führungsschienen verschiebare Lagerplatte (8) aufweist, der Antrieb an der Platte befestigt ist und die zweite Backe ebenfalls auf den Führungsschienen verschiebbar gehalten ist.

3. Pneumatischer Greifer nach Anspruch 1, **dadurch gekennzeichnet,** daß er ein erstes Steuerventil (16) zur selektiven Zufuhr eines Druckes (P1) zur Expansionskammer des Zylinders sowie ein zweites Steuerventil (18) zur selektiven Zufuhr eines gegenüber dem Druck (T1) niedrigeren Druckes (P2) zur Kontraktionskammer des Zylinders aufweist.

FIG.1

FIG.2

FIG.3

FIG.4

EP 0 205 141 B1

FIG. 5